# EUROPEAN PATENT APPLICATION

(11) **EP 3 557 293 A1**
(43) Date of publication of application: **23.10.2019**
(21) Application number: 17880840.8
(22) Date of filing: 01.12.2017
(51) Int. Cl.: G02B 5/20, F21V 9/00, F21V 9/08, F21V 29/502, F21V 29/85, H01L 33/50, F21Y 115/30

(54) **OPTICAL COMPONENT**

(30) Priority: 13.12.2016 JP 2016241036
(71) Applicant: NGK Insulators, Ltd., Nagoya-shi, Aichi 467-8530 (JP)
(72) Inventor: KONDO Jungo, Nagoya-shi Aichi 467-8530 (JP); OKADA Naotake, Nagoya-shi Aichi 467-8530 (JP); ASAI Keiichiro, Nagoya-shi Aichi 467-8530 (JP); HIGASHIHARA Shuhei, Nagoya-shi Aichi 467-8530 (JP); YAMAGUCHI Shoichiro, Nagoya-shi Aichi 467-8530 (JP)
(74) Representative: Müller-Boré & Partner Patentanwälte PartG mbB
(86) International application number: PCT/JP2017/043249
(87) International publication number: WO 2018/110316

(57) **Abstract**

An optical component (50) includes a first substrate (10) including a phosphor substrate (11) and a second substrate (20) including a translucent substrate (21) and supporting the first substrate (10). A bonding layer (30) is provided between the first substrate (10) and the second substrate (20), and the bonding layer includes at least one kind of element contained on a surface of the first substrate (10) facing the second substrate (20) and at least one kind of element contained on a surface of the second substrate (20) facing the first substrate (10). The bonding layer (30) contains 2% by weight or more and 45% by weight or less of at least one kind of metal element which is not included in any of the first substrate (10) and the second substrate (20).

## Description

### Technical Field

The present invention relates to an optical component, and more particularly to an optical component including a phosphor substrate.

### Background Art

According to WO2011/141377 (Patent Document 1), a headlight module including a support for supporting a phosphor and a radiation source for electromagnetic radiation to the phosphor is disclosed. The support is exemplified by polycrystalline alumina ceramics or sapphire. Both materials are suitable for application to a headlight, which is a lighting device that is prone to increase in temperature and unevenness in temperature distribution, in terms of the materials having high heat resistance and high thermal conductivity. As a phosphor, yttrium aluminum garnet (YAG) doped with cerium (Ce) is exemplified. A blue light emitting laser is exemplified as a radiation source. The blue laser light is converted into white light by the phosphor. This allows the headlight module to emit white light.

According to Japanese Patent Application Laid-Open No. 2016-157905 (Patent Document 2), an optical component including a translucent support and a phosphor single crystal is disclosed. The translucent support and the phosphor single crystal may be bounded to each other by direct bonding.

### Prior Art Documents

### Patent Documents

[Patent Document 1] WO2011/141377
[Patent Document 2] Japanese Patent Application Laid-Open No. 2016-157905

### Summary

### Problem to be Solved by the Invention

In order to suppress the temperature rise and the unevenness of the temperature distribution of the phosphor, increase in thermal conductivity from the phosphor to the support is required. Therefore, when an optical component including a supporting substrate and a supported substrate including a phosphor is produced, bonding of the supporting substrate and the supported substrate to each other so as not to significantly impede the thermal conductivity between the two is required. In this respect, direct bonding is a preferred bonding method. However, even when direct bonding is used, there can be non-negligible thermal resistance. Therefore, a technique that can further improve the thermal conductivity between the supporting substrate and the supported substrate has been sought.

The present invention has been made to solve the above problems, and the object thereof is to provide an optical device capable of enhancing the thermal conductivity between a supported substrate including a phosphor and a supporting substrate supporting the supported substrate.

### Means to Solve the Problem

An optical component according to the present invention includes a first substrate and a second substrate. The first substrate includes a phosphor substrate. The second substrate includes a translucent substrate and supporting the first substrate. A bonding layer is provided between the first substrate and the second substrate, and the bonding layer includes at least one kind of element contained on a surface of the first substrate facing the second substrate and at least one kind of element contained on a surface of the second substrate facing the first substrate. The bonding layer contains 2% by weight or more and 45% by weight or less of at least one kind of metal element which is not contained in any of the first substrate and the second substrate.

### Effects of the Invention

According to the present invention, the bonding layer contains 2% by weight or more and 45% by weight or less of at least one kind of metal element which is not contained in any of the first substrate and the second substrate in addition to at least one kind of element contained on a surface of the first substrate facing the second substrate and at least one kind of element contained on a surface of the second substrate facing the first substrate. The presence of the metal element enhances the thermal conductivity between the first substrate including the phosphor substrate and the second substrate supporting the first substrate.

These and other objects, features, aspects and advantages of the present invention will become more apparent from the following detailed description of the present invention when taken in conjunction with the accompanying drawings.

### Brief Description of Drawings

[FIG. 1] A sectional view schematically illustrating a configuration of a lighting device including an optical component according to Embodiment 1 of the present invention.
[FIG. 2] A partial enlarged view of FIG. 1 and partial sectional view schematically illustrating the vicinity of a bonding layer between a supported substrate and a supporting substrate in an optical component.
[FIG. 3] A sectional view schematically illustrating a configuration of an optical component according to Embodiment 2 of the present invention.
[FIG. 4] A partial enlarged view of FIG. 3 and partial sectional view schematically illustrating the vicinity of a bonding layer between a supported substrate and a supporting substrate in an optical component.
[FIG. 5] A sectional view schematically illustrating a first step of a manufacturing method of the optical component of FIG. 3.
[FIG. 6] A sectional view schematically illustrating a second step of the manufacturing method of the optical component of FIG. 3.
[FIG. 7] A sectional view schematically illustrating a third step of the manufacturing method of the optical component of FIG. 3.
[FIG. 8] A sectional view schematically illustrating a fourth step of the manufacturing method of the optical component of FIG. 3.
[FIG. 9] Modification of FIG. 4.

### Description of Embodiments

Hereinafter, Embodiments of the present invention is described with reference to the drawings.

### <Embodiment 1>

### (Configuration)

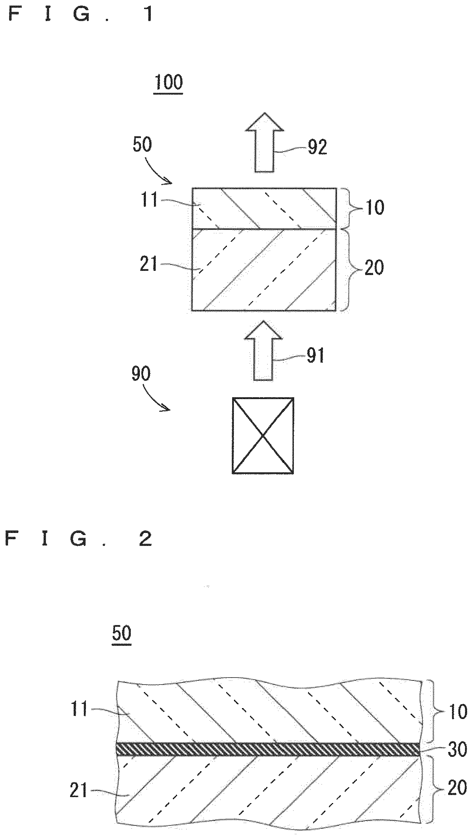

Referring to FIG. 1, a lighting device 100 includes a light source 90, a wavelength conversion member 50 (optical component). The light source 90 is, for example, a semiconductor laser. The wavelength conversion member 50 converts a light wavelength by the phosphor. Excitation light 91 from the light source is converted into illumination light 92 by passing through the wavelength conversion member 50. For example, the excitation light 91 is blue light or ultraviolet light, and the illumination light 92 is white light.

The wavelength conversion member 50 includes a supported substrate 10 (first substrate) and a supporting substrate 20 (second substrate) that supports the supported substrate 10. When a lighting device 100 is used, light passing through both the supported substrate 10 and the supporting substrate 20 is provided by the light source 90. Although the traveling direction of light is directed from the supporting substrate 20 to the supported substrate 10 in the drawing, the traveling direction of light may be reversed. As Modification, light passing only through the supported substrate 10 may be provided from the light source. The supported substrate 10 includes a phosphor substrate 11, and in Embodiment 1, the supported substrate 10 is the phosphor substrate 11. The supporting substrate 20 includes a translucent substrate 21, and in Embodiment 1, the supporting substrate 20 is the translucent substrate 21.

The phosphor substrate 11 is a substrate including a phosphor. The phosphor substrate 11 includes, for example, doped YAG.

The phosphor substrate 11 may be a phosphor single-crystal substrate or a phosphor polycrystalline substrate, for example. The phosphor polycrystalline substrate may be a substrate substantially consisting only of phosphor crystal grains, or may be a substrate formed by firing ceramic slurry in which phosphor particles are dispersed. Alternatively, the phosphor substrate 11 may be the one having a binder such as glass or resin, and a phosphor dispersed in the binder. That is, the phosphor substrate 11 may be the one in which a large number of phosphor particles are bound by the binder.

The translucent substrate 21 is a substrate having translucency and, preferably, is a substantially transparent substrate. The translucent substrate 21 may be a single-crystal substrate or a polycrystalline substrate, for example. The polycrystalline substrate may be formed as ceramics (sintered body). The single-crystal substrate is, for example, a sapphire substrate. The linear transmittance of the translucent substrate 21 is preferably about 70% or more per 0.5 mm in thickness in the wavelength range used by the lighting device 100, from the viewpoint of loss control. Meanwhile, from the viewpoint of suppressing color unevenness, it is preferable that the linear transmittance of the translucent substrate 21 is low. Specifically, in the case where a single-crystal substrate is used as the phosphor substrate 11, the linear transmittance is preferably less than 80%, however, in the case where a polycrystalline substrate is used as the phosphor substrate 11, the linear transmittance of 80% or higher may be allowable. In the case where a polycrystalline substrate is used as the phosphor substrate 11, excitation light is prone to scatter in the phosphor substrate 11 and color unevenness is suppressed by sufficient overlapping of the scattered light and fluorescence.

Preferably, the thermal conductivity of the translucent substrate 21 is higher than the thermal conductivity of the phosphor substrate 11. The thickness of the translucent substrate 21 is, for example, about 1 mm. It is preferable that the translucent substrate 21 have a substantially constant refractive index in the horizontal direction (lateral direction in the drawing). The translucent substrate 21 preferably has substantially no pores. Microscopic observation of about 5000 magnifications, for example, is conducted to observe the pores. The surface to be observed is preferably finished by polishing using ion milling so as to prevent the grain shedding when the surface to be observed is prepared.

The translucent substrate 21 preferably includes of alumina (Al₂O₃) or aluminum nitride as a main component. 99% or more is preferable as for the ratio for which the main component accounts among the components of the translucent substrate 21, and 99.99% or more is more preferable. Preferably, the linear thermal expansion coefficient of the translucent substrate 21 is within ±30% of the linear thermal expansion coefficient of the phosphor substrate 11. Here, the linear thermal expansion coefficient is in the in-plane direction (lateral direction in the figure).

Referring to FIG. 2, the wavelength conversion member 50 includes a bonding layer 30 between the supported substrate 10 and the supporting substrate 20, and this is microscopically observed with an electron microscope or the like. The bonding layer 30 is an interface layer formed by direct bonding between the supported substrate 10 and the supporting substrate 20. Diffusion of atoms occurs at the time of direct bonding; therefore, the bonding layer 30 includes at least one kind of element included on the surface (lower surface in the drawing) of the supported substrate 10 facing the supporting substrate 20 and at least one kind of element included on the surface (upper surface in the drawing) of the supporting substrate 20 facing the supported substrate 10. In Embodiment 1 in particular, the bonding layer 30 is an interface layer formed by direct bonding between the phosphor substrate 11 and the translucent substrate 21. Therefore, the bonding layer 30 includes at least one kind of element included in the phosphor substrate 11 and at least one kind of element included in the translucent substrate 21. The thickness of the bonding layer 30 is preferably about 1 nm or more and about 100 nm or less, and more preferably 1 nm or more and 10 nm or less. Note that, strictly speaking, the bonding layer 30 is present; therefore, it can be said that the phosphor substrate 11 is supported by the translucent substrate 21 via the bonding layer 30.

The bonding layer 30 contains 2% by weight or more and 45% by weight or less of at least one kind of metal element which is not contained in any of the supported substrate 10 and the supporting substrate 20. Here, "at least one kind of metal element not included in any of the supported substrate 10 and the supporting substrate 20" signifies at least one kind of metal element not included in any of the supported substrate 10 and the supporting substrate 20 as a main component and signifies, for example, at least one kind of metal element which is not contained in 1% by weight or more in any of the supported substrate 10 and the supporting substrate 20. If a plurality of metal elements that satisfy the condition are present in the bonding layer 30, the value of the weight percent is the sum of the weight percentages of the metal elements. Preferably, at least any of iron (Fe), chromium (Cr) and nickel (Ni) is used as the metal element. As described in detail in Embodiment 2, at the time of manufacturing the wavelength conversion member 50, the metal element is added into at least one of, or preferably both of, the surface of the supported substrate 10 and the surface of the supporting substrate 20 to be directly bonded to each other. The direct bonding is performed after the addition; therefore, the bonding layer 30 contains the above-described metal element.

### (Effects)

The bonding layer 30 includes at least one kind of element included on the surface of the supported substrate 10 facing the supporting substrate 20 and at least one kind of element included on the surface of the supporting substrate 20 facing the supported substrate 10. Such a bonding layer 30 can be formed by direct bonding as described above. By using direct bonding, obstruction of thermal conduction from the supported substrate 10 to the supporting substrate 20 at the bonding portion is suppressed.

Further, the bonding layer 30 contains 2% by weight or more and 45% by weight or less of at least one kind of metal element which is not contained in any of the supported substrate 10 and the supporting substrate 20. First, the significant presence of this metal element enhances the metal-bond properties in the bonding layer 30. Thereby, the thermal conductivity between the supported substrate 10 and the supporting substrate 20 is enhanced. Second, the presence of the metal element is not excessive; therefore, the absorption and scattering of light due to the metal element are prevented from becoming too large. Thereby, great disturbance of the optical characteristics of the wavelength conversion member 50 due to the presence of the metal element in the bonding layer 30 is avoided. As described above, according to Embodiment 1, heat dissipation from the supported substrate 10 to the supporting substrate 20 can be promoted while maintaining the optical characteristics of the wavelength conversion member 50.

Preferably, the thermal conductivity of the translucent substrate 21 is higher than the thermal conductivity of the phosphor substrate 11. Thus, the heat radiation from the phosphor substrate 11 can be promoted. Therefore, deterioration in performance due to the temperature rise of the phosphor substrate 11 can be suppressed.

Preferably, the linear thermal expansion coefficient of the translucent substrate 21 is within ±30% of the linear thermal expansion coefficient of the phosphor substrate 11. Thus, occurrence of cracking of the phosphor substrate 11 due to the difference in thermal expansion can be prevented. The remarkable effect is obtained particularly in the case where the difference in thickness is large, like when the thickness of the phosphor substrate 11 is about 100 µm or less and the thickness of the translucent substrate 21 is 1 mm or more.

### <Embodiment 2>

### (Configuration)

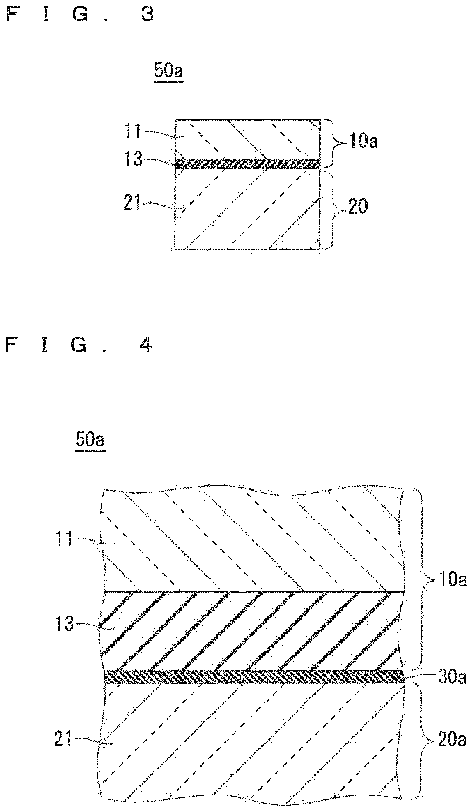

Referring to FIG. 3, the wavelength conversion member 50a (optical component) of Embodiment 2 includes a supported substrate 10a (first substrate) instead of the supported substrate 10 (FIG. 1). The supported substrate 10a includes an intermediate layer 13 facing the supporting substrate 20. Therefore, the bonding layer 11 is supported by the phosphor substrate 21 via the intermediate layer 13. The intermediate layer 13 is made of a material different from the material of the phosphor substrate 11. The intermediate layer 13 is a layer having translucency, and is preferably substantially transparent. Preferably, the thickness of the intermediate layer 13 is 1 µm or less. Preferably, the thermal conductivity of the intermediate layer 13 is higher than the thermal conductivity of the phosphor substrate 11. The material of the intermediate layer 13 is preferably oxide, for example, alumina (Al₂O₃), however, in the viewpoint of the ease of direct bonding, tantalum oxide (Ta₂O₅) may be applicable. When the wavelength conversion member 50a is used for applications such as a waveguide-type phosphor, it is preferable that the refractive index of the intermediate layer 13 is smaller than the refractive index of the phosphor substrate 11.

Referring to FIG. 4, the wavelength conversion member 50a of Embodiment 2 includes a bonding layer 30a instead of the bonding layer 30 (FIG. 2). The bonding layer 30a is an interface layer formed by direct bonding between the supported substrate 10a and the supporting substrate 20. Therefore, the bonding layer 30a includes at least one kind of element included on the surface (lower surface in the drawing) of the supported substrate 10a facing the supporting substrate 20 and at least one kind of element included on the surface (upper surface in the drawing) of the supporting substrate 20 facing the supported substrate 10a. In Embodiment 2 in particular, the bonding layer 30a is an interface layer formed by direct bonding between the intermediate layer 13 and the translucent substrate 21. Therefore, the bonding layer 30a includes at least one kind of element included in the intermediate layer 13 and at least one kind of element included in the translucent substrate 21. Strictly speaking, the bonding layer 30a is present; therefore, it can be said that the phosphor substrate 11 is supported by the translucent substrate 21 via the intermediate layer 13 and the bonding layer 30a. Except for the above, the bonding layer 30a is similar to the bonding layer 30 (FIG. 2), and includes the metal element as in the case of the bonding layer 30.

The configuration other than the above is substantially the same as that of the above-described Embodiment 1, therefore, the same or corresponding elements are denoted by the same reference numerals, and description thereof will not be repeated.

### (Manufacturing method)

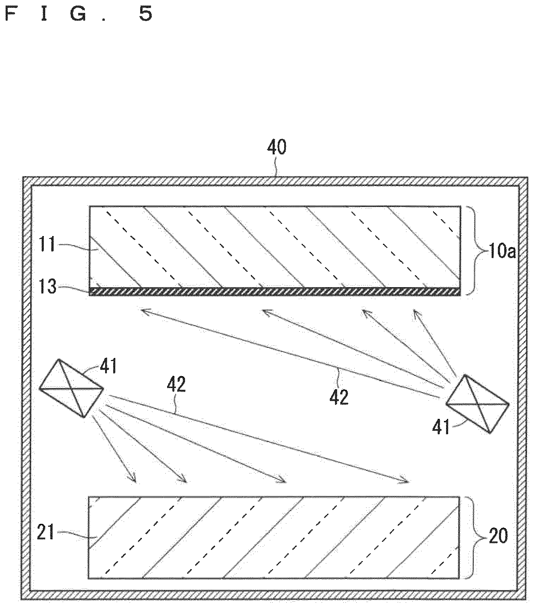

The manufacturing method of the wavelength conversion member 50a is described below with reference to FIGS 5 to 8.

Referring to FIG. 5, the intermediate layer 13 is formed on the phosphor substrate 11 (on the lower surface in the drawing). Thus, the supported substrate 10a having the phosphor substrate 11 and the intermediate layer 13 is obtained. In addition, the translucent substrate 21 as the supporting substrate 20 is prepared. The supported substrate 10a and the supporting substrate 20 are transported into the vacuum chamber 40.

The particle beam 42 is irradiated from the particle beam generator 41 to each of the surface of the intermediate layer 13 of the supported substrate 10a and the surface of the supporting substrate 20. This makes both surfaces suitable for direct bonding. For example, the particle beam generator 41 is an ion gun, and the particle beam 42 is an ion beam. Alternatively, the particle beam generator 41 is a fast atom beam (FAB) gun and the particle beam 42 is a FAB. The particle beam 42 includes a metal ion beam or a metal atom beam. An example of such a beam generation method will be described below.

Within the particle beam generator 41, first, an ion beam or an atom beam of a rare gas is generated. The beam strikes a metal grid mounted in an opening as the exit of the particle beam generator 41. Thereby, metal is emitted from the metal grid as ions or atoms. That is, the ion beam or the atom beam of the rare gas is mixed with an ion beam or atom beam of the metal. Therefore, the metal elements are added onto the surface of the intermediate layer 13 of the supported substrate 10a and the surface of the supporting substrate 20. The amount to be added can be adjusted by the type of beam, energy, irradiation time and the like. Note that, the addition amount can be easily increased by using FAB rather than ion beam.

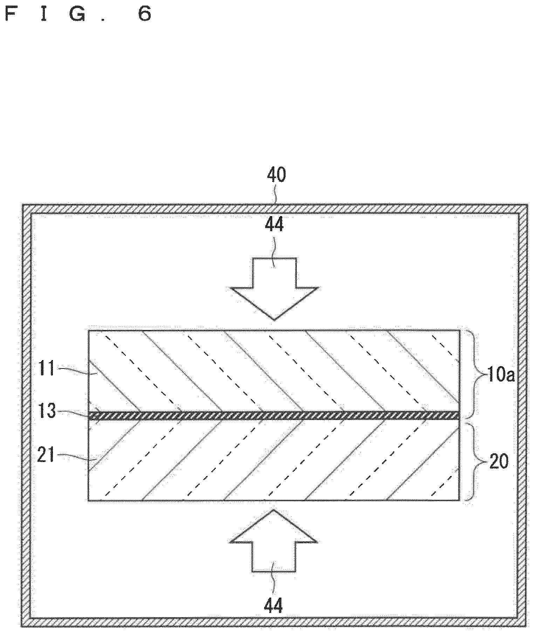

Further, referring to FIG. 6, the above surfaces in pair are brought into contact with one another. Then, the supported substrate 10a and the supporting substrate 20 are mutually pressed by the load 44. Therefore, the supported substrate 10a and the supporting substrate 20 are mutually bounded by the direct bonding. The bonding temperature may be a normal temperature or higher than the normal temperature. The diffusion of substances is particularly significantly promoted if it is high temperatures, in particular temperatures about 800°C or higher is used. Therefore, the smoothness of the surface to be bounded is not strictly required than in the case of the normal temperature. Therefore, if a high bonding temperature is acceptable, it can be used to reduce cost or increase yield. In the case of high bonding temperature, in particular, the linear thermal expansion coefficient of the translucent substrate 21 is preferably within ±30% of the linear thermal expansion coefficient of the phosphor substrate 11. As a result, prevention of the breakage of either of the substrates due to the stress from the thermal contraction at the time of temperature drop after bonding is ensured.

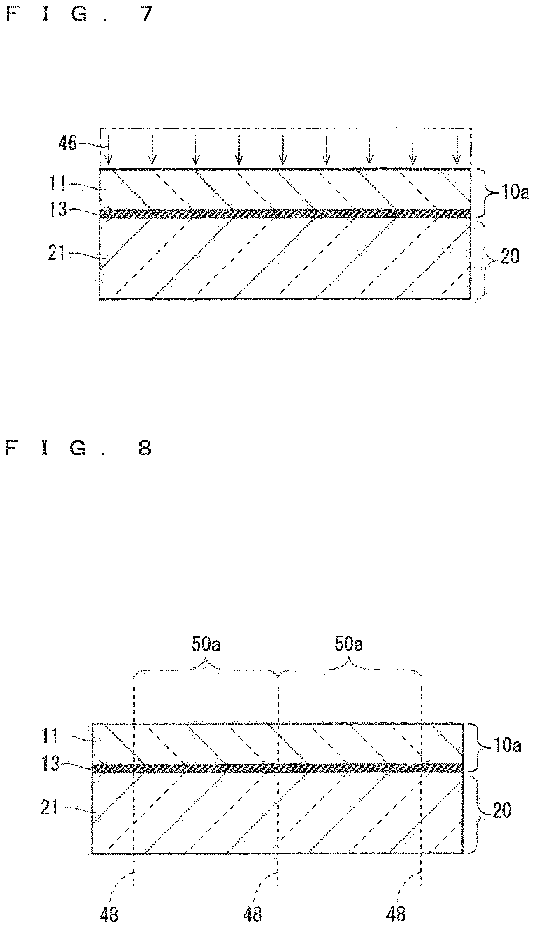

Referring to FIG. 7, the thickness of phosphor substrate 11 is reduced by polishing 46, if necessary. Referring to FIG. 8, one or more wavelength conversion members 50a are cut out along the dicing line 48 from the laminated body of the supported substrate 10a and the supporting substrate 20 obtained by the above bonding. After that, a reflective film can be formed on the dicing cut surface so that fluorescence can be extracted with high efficiency in the direction of the illumination light 92 (FIG. 1) as in the case of the excitation light. Examples of the reflective film include silver, copper, gold, aluminum, and mixed crystal films containing these materials.

Thus, the wavelength conversion member 50a (FIG. 3) is obtained. It should be noted that, if the above manufacturing method is implemented without forming the intermediate layer 13, the wavelength conversion member 50 (FIG. 1: Embodiment 1) will be obtained.

### (Effects)

The same effects as above-described Embodiment 1 are also obtained with Embodiment 2.

Further, according to Embodiment 2, the supported substrate 10a includes the intermediate layer 13 facing the supporting substrate 20 and the intermediate layer 13 is made of a material different from the material of the phosphor substrate 11. Thus, the material of the surface of the supported substrate 10a facing the supporting substrate 20 can be made suitable for bonding with the supporting substrate 20. This facilitates the bonding of the supported substrate 10a and the supporting substrate 20, and in particular, facilitates the direct bonding in which the combination of materials is significant. It should be noted that the material of the intermediate layer 13 may be the same as the material of the translucent substrate 21, and in that case, direct bonding is more readily implemented.

### (Modification)

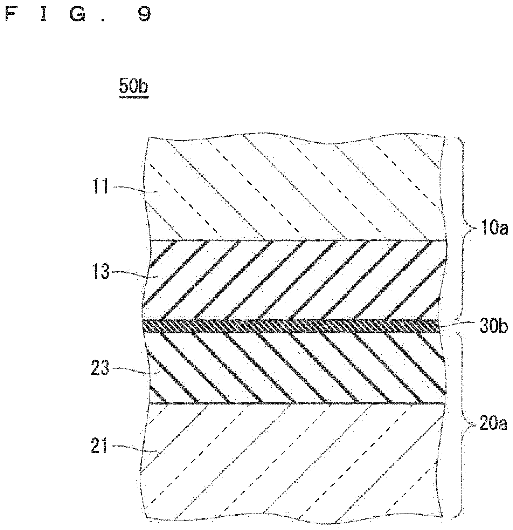

Referring to FIG. 9, the wavelength conversion member 50b (optical component) of Modification includes a supporting substrate 20a (second substrate) instead of the supporting substrate 20 (FIG. 3). The supporting substrate 20a includes an intermediate layer 23 facing the supported substrate 10a. Therefore, the phosphor substrate 11 is supported by the translucent substrate 21 via the intermediate layer 13 and the intermediate layer 23. The intermediate layer 23 is made of a material different from the material of the translucent substrate 21. The intermediate layer 23 is a layer having translucency, and is preferably substantially transparent. Preferably, the thickness of the intermediate layer 23 is 1 µm or less. Preferably, the thermal conductivity of the intermediate layer 23 is higher than the thermal conductivity of the phosphor substrate 11. The material of the intermediate layer 23 is preferably oxide, for example, alumina or tantalum oxide.

Further, the wavelength conversion member 50b includes a bonding layer 30b instead of the bonding layer 30a (FIG. 4). The bonding layer 30b is an interface layer formed by direct bonding between the supported substrate 10a and the supporting substrate 20a. Therefore, the bonding layer 30b includes at least one kind of element included on the surface (lower surface in the drawing) of the supported substrate 10a facing the supporting substrate 20a and at least one kind of element included on the surface (upper surface in the drawing) of the supporting substrate 20a facing the supported substrate 10a. In Modification in particular, the bonding layer 30b is an interface layer formed by direct bonding between the intermediate layer 13 and the intermediate layer 23. Therefore, the bonding layer 30b includes at least one kind of element included in the intermediate layer 13 and at least one kind of element included in the intermediate layer 23. Strictly speaking, the bonding layer 30b is present; therefore, it can be said that the phosphor substrate 11 is supported by the translucent substrate 21 via the intermediate layer 13, the intermediate layer 23, and the bonding layer 30b. Except for the above, the bonding layer 30b is similar to the bonding layer 30a (FIG. 4), and includes the metal element as in the case of the bonding layer 30a.

Substantially the same effects as Embodiment 2 are also obtained with Modification. It should be noted that the material of the intermediate layer 23 may be the same as the material of the intermediate layer 13, and in that case, direct bonding is more readily implemented.

### [Example]

### (Experiment A)

A single-crystal YAG substrate doped with Ce atoms was prepared as the phosphor substrate 11 (FIG. 5). An alumina layer having a thickness of 0.5 µm was formed as the intermediate layer 13 (FIG. 5) on the phosphor substrate 11 by sputtering. The obtained layer had a surface roughness Ra of 0.5 nm. A sapphire substrate having a thickness of 1 mm was prepared as the supporting substrate 20 (FIG. 5). The alumina layer and the sapphire substrate were directly bonded. Specifically, first, as the particle beam 42 (FIG. 5), the ion beam as described in Embodiment 2 was irradiated on the both surfaces. The ion gun made by Mitsubishi Heavy Industries, Ltd. is used as an ion gun therefor. Next, the both were brought into contact under vacuum and at the normal temperature, and the load 44 (FIG. 6) was applied. That is, bonding was performed. Next, polishing 46 (FIG. 7) reduced the thickness of phosphor substrate 11 to 200 µm within errors of ±0.25 µm. The polishing 46 was performed with accuracy of optical polishing. Specifically, grinder grinding, lapping and chemical mechanical polishing (CMP) were sequentially performed. Next, a wavelength conversion member is cut out with a size of 3 mm square using a dicing unit.

Further, a composite substrate using direct bonding was produced on the conditions similar to the above. Then, the bonding layer was observed with a Transmission Electron Microscope (TEM). As a result, the thickness of the bonding layer was about 5 nm. The composition of the bonding layer was also evaluated by Energy Dispersive X-ray spectrometry (EDX). As a result, Fe, Cr and Ni were observed as metal elements, and particularly, Fe was mainly observed. For this reason, when the weight percent of the metal element was evaluated, the values of Cr and Ni were ignored and the value of Fe was used.

In the production of the wavelength conversion member described above, the amount of the metal element in the bonding layer was controlled by adjusting the irradiation intensity and the irradiation time of the ion gun that generated an ion beam. Therefore, six wavelength conversion members each having 0 wt%, 2 wt%, 10 wt%, 30 wt%, 45 wt%, 50 wt% and 60 wt% as weight percent (wt%) of Fe element in the bonding layer were prepared as samples. As a light source 90 (FIG. 1), a GaN-based blue laser device with an output of 10 W and a wavelength of 450 nm was prepared. The excitation light 91 (FIG. 1) generated using the device was irradiated on the wavelength conversion member. The output of the illumination light 92 (FIG. 1) obtained by passing this light through the wavelength conversion member was evaluated. The results are shown in Table 1 below.

**[Table 1]**

| | | | | | | | |
|---|---|---|---|---|---|---|---|
| concentration of Fe | 0 wt% | 2 wt% | 10 wt% | 30 wt% | 45 wt% | 50 wt% | 60 wt% |
| output of illumination light | 3000 lm | 3200 lm | 3600 lm | 3600 lm | 3400 lm | 3000 lm | 1000 lm |

In addition, the measurement of the output of the illumination light 92 was performed in accordance with the stipulation of "JIS C 7801" in Japanese Industrial Standards (JIS). Specifically, the measurement was performed by time averaging of the total luminous flux from the wavelength conversion member. The measurement of total luminous flux was performed using an integrating sphere (sphere photometer). The light source to be measured and the standard light source for which the total luminous flux had been valued were turned on at the same position, and the measurement was performed by comparing the two.

In addition, for each of the wavelength conversion members in the above table, the color unevenness of the illumination light 92 (FIG. 1) was also evaluated. As a result, it was evaluated that there was no color unevenness in any of the wavelength conversion members. Color unevenness was evaluated by the chromaticity diagram obtained using the luminance distribution measuring device. In the chromaticity diagram, when the measurement result was in the range of median x: 0.3447 ±0.005, y: 0.3553 ±0.005, it was determined that there was no color unevenness.

### (Experiment B)

A polycrystalline YAG substrate doped with Ce atoms was prepared as the phosphor substrate 11 (FIG. 5). An alumina layer having a thickness of 0.5 µm was formed as the intermediate layer 13 (FIG. 5) on the phosphor substrate 11 by sputtering. The obtained layer had a surface roughness Ra of 0.5 nm. A sapphire substrate having a thickness of 1 mm was prepared as the supporting substrate 20 (FIG. 5). The alumina layer and the sapphire substrate were directly bonded as in Experiment A above. Next, polishing 46 (FIG. 7) reduced the thickness of phosphor substrate 11 to 100 µm within errors of ±0.25 µm by the same method as in Experiment A above. Next, a wavelength conversion member was cut out with a size of 3 mm square using a dicing unit.

Further, a composite substrate using direct bonding was produced on the conditions similar to the above. And the joining layer was observed by the TEM. As a result, the thickness of the bonding layer was about 5 nm. Also, the composition of the bonding layer was evaluated by the EDX, as a result, Fe, Cr and Ni were observed as metal elements, and particularly, Fe was mainly observed as in Experiment A above.

In the production of the wavelength conversion member described above, the amount of the metal element in the bonding layer was controlled by adjusting the irradiation intensity and the irradiation time of the ion gun that generates an ion beam. Therefore, six wavelength conversion members each having 0 wt%, 2 wt%, 10 wt%, 30 wt%, 45 wt%, 50 wt% and 60 wt% as weight concentration of Fe element in the bonding layer were prepared as samples. As a light source 90 (FIG. 1), a GaN-based blue laser device with an output of 10 W and a wavelength of 450 nm was prepared. The excitation light 91 (FIG. 1) generated using the device was irradiated on the wavelength conversion member. The output of the illumination light 92 (FIG. 1) obtained by passing this light through the wavelength conversion member was evaluated by the same method as in Experiment A above. The results are shown in Table 2 below.

**[Table 2]**

| | | | | | | | |
|---|---|---|---|---|---|---|---|
| concentration of Fe | 0 wt% | 2 wt% | 10 wt% | 30 wt% | 45 wt% | 50 wt% | 60 wt% |
| output of illumination light | 3000 lm | 3100 lm | 3500 lm | 3500 lm | 3300 lm | 3000 lm | 1000 lm |

Further, the color unevenness of the illumination light 92 (FIG. 1) of each wavelength conversion member was also evaluated by the same method as in Experiment A above. As a result, it was evaluated that there was no color unevenness in any of the wavelength conversion members.

### (Comparison between samples in Experiments A and B)

Referring to the results of Experiment A (Table 1), when the weight concentration of Fe atoms (that is, the concentration of the metal element) was 0 wt%, the output of the illumination light 92 was 300 lm. An output higher than this was obtained in the range of 2 wt% to 45 wt% of weight concentration. The results of Experiment B (Table 2) were also similar to this. From these results, when the Fe atoms are contained in the range of 2 wt% or more and 45 wt% or less in the bonding layer, the output of illumination light is enhanced compared to the case where the metal element is not substantially included in the bonding layer. The reason is considered to be that the thermal resistance in the bonding layer is reduced by the significant inclusion of Fe atoms in the bonding layer, and thus the heat dissipation from the phosphor substrate 11 is promoted. On the other hand, when the weight concentration of Fe atoms is excessively high, it is considered that light absorption or reflection by Fe atoms causes a large loss of light in the bonding layer, and thus the output of illumination light is reduced.

While the invention has been described in detail, the foregoing description is in all aspects illustrative and not restrictive. It is understood that numerous other modifications and variations can be devised without departing from the scope of the invention.

### Explanation of Reference Signs

- 10, 10a: supported substrate (first substrate)
- 11: phosphor substrate
- 13: intermediate layer (first intermediate layer)
- 23: intermediate layer (second intermediate layer)
- 20, 20a: supporting substrate (second substrate)
- 21: translucent substrate
- 30, 30a, 30b: bonding layer
- 40: vacuum chamber
- 41: particle beam generator
- 50, 50a, 50b: wavelength conversion member (optical component)
- 90: light source
- 91: excitation light
- 92: illumination light
- 100: lighting device

## Claims

1. An optical component (50, 50a, 50b) comprising:
a first substrate (10, 10a) including a phosphor substrate (11);
a second substrate (20, 20a) including a translucent substrate (21) and supporting the first substrate (10, 10a); and
a bonding layer provided between the first substrate (10, 10a) and the second substrate (20, 20a), the bonding layer including at least one kind of element contained on a surface of the first substrate (10, 10a) facing the second substrate (20, 20a) and at least one kind of element contained on a surface of the second substrate (20, 20a) facing the first substrate (10, 10a),
the bonding layer containing 2% by weight or more and 45% by weight or less of at least one kind of metal element which is not included in any of the first substrate (10, 10a) and the second substrate (20, 20a).

2. The optical component (50, 50a, 50b) according to claim 1, wherein
the at least one kind of element includes at least any of iron, chromium, and nickel.

3. The optical component (50, 50a, 50b) according to claim 1 or 2, wherein
the bonding layer has a thickness of 1 nm or more and 100 nm or less.

4. The optical component (50, 50a, 50b) according to any one of claims 1 to 3, wherein the translucent substrate (21) includes alumina or aluminum nitride.

5. The optical component (50a, 50b) according to any one of claims 1 to 4, wherein
the first substrate (10a) includes a first intermediate layer (13) facing the second substrate (20, 20a), and the first intermediate layer (13) is made of a material different from a material of the phosphor substrate (11).

6. The optical component (50b) according to claim 5, wherein
the second substrate (20a) includes a second intermediate layer (23) facing the first substrate (10a), and the second intermediate layer (23) is made of a material different from a material of the translucent substrate (21).
